Europäisches Patentamt

European Patent Office

Office européen des brevets

(19)

(11) Publication number: **0 061 309**
**A1**

(12) **EUROPEAN PATENT APPLICATION**

(21) Application number: **82301400.6**

(22) Date of filing: **18.03.82**

(51) Int. Cl.³: **H 01 B 7/08**
**H 01 P 3/08**

(30) Priority: **20.03.81 JP 42123/81**

(43) Date of publication of application:
**29.09.82 Bulletin 82/39**

(84) Designated Contracting States:
**AT BE DE FR IT NL SE**

(71) Applicant: **JUNKOSHA CO. LTD.**
**42-1, 1-chome Gotokuji**
**Setagaya-ku Tokyo 154(JP)**

(72) Inventor: **Suzuki, Hirosuke**
**4-21-8, Kotesashi-cho**
**Tokorozawa Saitama(JP)**

(74) Representative: **Taylor, Derek George et al,**
**MATHISEN, MACARA & CO. European Patent Attorneys**
**Lyon House Lyon Road**
**Harrow Middlesex, HA1 2ET(GB)**

(54) An improved stripline.

(57) A stripline comprises a dielectric layer (1), and a plurality of sets of signal conductors (2) and wider ground conductors (3) the signal and ground conductors being disposed opposite each other with the dielectric layer sandwiched therebetween. The signal and ground conductors are alternately arranged in side-by-side spaced apart relationship. The dielectric layer is made of porous resin of ethylene tetrafluoride. With this arrangement, crosstalk in the stripline can greatly be reduced, and signals can be transmitted at higher speeds over the stripline.

FIG. 1

EP 0 061 309 A1

AN IMPROVED STRIPLINE

The present invention relates to a stripline.

Transmission lines for microwaves and millimetre-wave circuits include coaxial cables and striplines as well as wave-guides. The coaxial cables and striplines comprise two conductors which are capable of direct-current transmission, and hence are widely used in transmission circuits.

Striplines have received a great deal of attention for use in information processing equipment such as computers becuase they can be used as multiple-connection cables to construct relatively compact transmission lines. There is a requirement for a stripline which is subject to only low levels of crosstalk and is suitable for use in transmitting high-speed pulses.

According to the present invention, there is provided a stripline comprising a dielectric layer and a plurality of sets of signal conductors and wider ground conductors, the signal and ground conductors being disposed opposite each other with the dielectric layer sandwiched therebetween, said signal and ground conductors being alternately arranged in side-by-side spaced apart relationship on each side of the dielectric layer.

With this arrangement, crosstalk in the stripline can greatly be reduced, and further reduced by having the ground conductors thicker than the signal conductors.

The dielectric layer is preferably made of porous resin of ethylene tetrafluoride to provide a physically and chemically stable dielectric material of a low dielectric constant.

The invention will now be particularly described by way of example, with reference to the accompanying drawings in which:-

Figure 1 is a transverse cross-sectional view of a stripline according to an embodiment of the present invention;

Figure 2 is a transverse cross-sectional view of a stripline according to another embodiment;

Figure 3 is a transverse cross-sectional view of a stripline according to still another embodiment; and

Figure 4 is a fragmentary schematic view explanatory of the manner in which a stripline of the present invention operates.

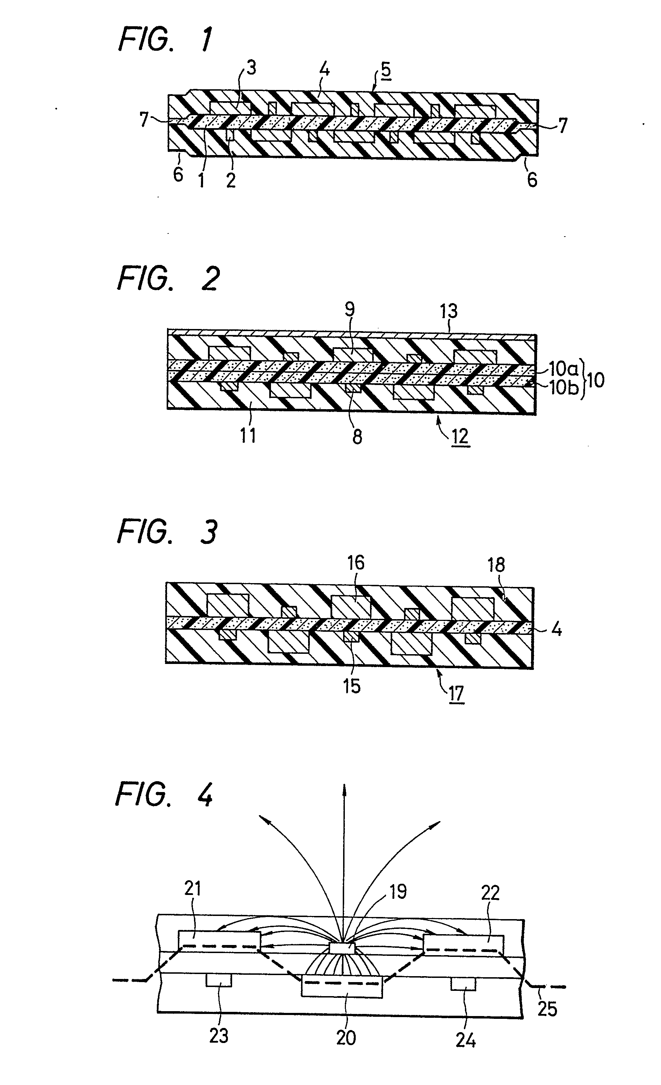

As shown in Figure 1, a stripline comprises a dielectric layer 1 made of porous resin of ethylene tetrafluoride, and a plurality of sets of signal conductors 2 and wider ground conductors 3, the signal and ground conductors being disposed opposite each other with the dielectric layer 1 sandwiched therebetween. The signal and ground conductors 2, 3 on each side of the dielectric layer are alternately arranged in side-by-side spaced apart relationship. The signal and ground conductors 2, 3 and the dielectric layer 1 are encased in a cover layer 4 made of solid resin of ethylene tetrafluoride. For assembly, the above components are arranged as shown in Figure 1, and pressed, with the application of heat, between heated rolls (not shown). The dielectric layer 1 and the cover layer 4 are caused to be thermally fused together, retaining the sets of signal and ground conductors 2, 3 stably within the fused mass. Thus, the completed stripline 5 is highly stable in dimension and shape. The heated rolls are flanged to compress lateral edges 6 of the stripline 5 so that the dielectric layer 1 will have its lateral edges pressed into thinner compressed portions 7. The compressed portions 7 of the dielectric layer 1 are of reduced porosity and hence have a larger dielectric constant than that of the remainder of the dielectric layer 1. This arrangment reduces crosstalk between the lateral edges of the stripline 5 and other transmission lines.

According to another embodiment as shown in Figure 2, a dielectric layer 10 is composed of a pair of joined first and second layers 10a, 10b made of porous resin of ethylene tetrafluoride, and a plurality of sets of signal conductors 8 and wider ground conductors 9, the signal and ground conductors being disposed opposite each other with the dielectric layer 10 sandwiched therebetween. The signal and ground conductors 8, 9 on each side of the dielectric layer are arranged alternately in side-by-side spaced apart relationship. The signal and ground conductors 8, 9 and the dielectric layer 10 are encased in a cover 11 of solid resin of ethylene tetrafluoride, thus forming a stripline 12. The stripline 12 has on its one surface a shield layer 13 extending the full width thereof.

Where the layer members 10a, 10b are made of porous resin of ethylene tetrafluoride, they can be thermally fused to provide a required degree of bonding strength. The layer members 10a, 10b are separable from each other when they are subjected to a certain amount of stress or higher. Thus, the conductors 8, 9 can easily be processed for terminal splicing or connection. Since the cover 11 and the first layer 10a or the second layer 10b are bonded together with sufficient strength, there is no danger of the conductors 8, 9 coming off the cover 11. With the shield layer 13 disposed on one side of the stripline 12, no crosstalk will be created between a stack of such striplines 12.

Figure 3 illustrates a stripline 17 according to still another embodiment of the present invention. The stripline 17 comprises a dielectric layer 14, and a plurality of sets of signal conductors 15 and wider ground conductors 16 arranged as in the embodiments of Figures 1 and 2. However, the ground conductors 16 are much thicker than the signal conductors 15. The dielectric layer 14 and the signal and ground conductors 15, 16 are encased in a cover 18. With the ground conductors 16 thicker than the signal conductors 15, the signal conductors 15 are more shielded by the cover 18 than the ground conductors 16, rendering the stripline 17 freer from crosstalk.

With arrangments of the present invention, the signal conductors and the wider ground conductors are alternately positioned on each side of the dielectric layer, with signal and gound conductors opposite each other. As shown in Figure 4, such a construction forms a zigzag or staggered ground line 25 as indicated by the dotted line. Lines of electric force extending from a signal conductor 19 reach an opposite ground conductor 20 in the same set and adjacent ground conductors 21, 22 in adjacent sets, but almost fail to reach signal conductors 23, 24 in the adjacent sets. Accordingly, substantially no crosstalk results from the striplines of the present invention.

Experiments conducted on the stripline 5 as illustrated in Figure 1 indicated that when a pulse having a rise time of 2.5 ns was applied to 10 metres of the stripline, the rate of attenuation of forward crosstalk between adjacent conductors was 0.45%, the rate of attenuation of backward crosstalk between adjacent conductors was 0.54%, and the rate of attenuation of crosstalk between conductors in different layers was half those described above or less. The same rates of attenuation resulted from experimentation with 3 metres of the stripline.

According to similar experiments with a conventional stripline, the rate of attenuation of forward crosstalk between adjacent conductors was 2.4%, and the rate of attenuation of backward crosstalk between adjacent conductors was 5.1%. Thus, the stripline according to the present invention reduced the rate of attenuation of forward crosstalk between adjacent conductors to about 1/5, and the rate of attenuation of backward crosstalk between adjacent conductors to about 1/9.

The stripline according to the present invention greatly reduces crosstalk, and is quite effective when used for transmitting information. The stripline of the invention allows stable reception and transmission of signals at its ends with a low level of crosstalk.

The stripline of the present invention is also advantageous in that the alternate arrangement of conductors results in a smaller tranverse dimension than that of conventional striplines, and hence in a compact and lightweight stripline. The sets of conductors can be assembled in an increased density. With the dielectric layer made of porous resin of ethylene tetrafluoride, the stripline has a decreased transmission delay time and hence can transmit signals at higher speeds. Since the stripline does not increase the rise time of a signal pulse, the stripline can transmit signals having higher pulse repetition frequencies and is suitable for high-speed signal transmission.

The stripline with its dielectric layer and cover made of resin of ethylene tetrafluoride can continuously be used stably in a wide temperature range of +260°C, and can suitably be used in a wide range of frequencies.

Although certain preferred embodiments have been shown and described in detail, it should be understood various changes and modifications may be made therein without departing from the scope of the appended claims. For example, the dielectric layer and cover may be made of dielectric materials having a low dielectric constant other than ethylene tetrafluoride. Furthermore, the dielectric layer may contain a filler material and a colouring material.

8205:2JJK9

## CLAIMS

1.    A stripline comprising a dielectric layer, and a plurality of sets of signal conductors and wider ground conductors, the signal and ground conductors being disposed opposite each other with the dielectric layer sandwiched therebetween, said signal and ground conductors being alternately arranged in side-by-side spaced apart relationship on each side of the dielectric layer.

2.    A stripline according to claim 1, wherein said dielectric layer is made of porous resin of ethylene tetrafluoride, said dielectric layer and said sets of signal and ground conductors being covered with a layer of solid resin of ethylene tetrafluoride.

3.    A stripline according to claim 1 or claim 2, wherein said ground conductors are thicker than said signal conductors.

4.    A stripline according to claim 1, claim 2 or claim 3 including a shield layer disposed on at least one side of the stripline.

5.    A stripline according to any one of the preceding claims wherein said dielectric layer comprises a pair of layer members which are separable from each other by the application of force.

6.    A stripline according to claim 5, wherein said layer members are made of porous resin of ethylene tetrafluoride.

0061309

FIG. 1

FIG. 2

FIG. 3

FIG. 4

| | | European Patent Office | **EUROPEAN SEARCH REPORT** | | **0061309** Application number |
|---|---|---|---|---|---|

**EP 82301400.6**

## DOCUMENTS CONSIDERED TO BE RELEVANT

| Category | Citation of document with indication, where appropriate, of relevant passages | Relevant to claim |
|---|---|---|
| X | US - A - 3 459 879 (GERPHEIDE)<br>* Column 2, lines 20-51; column 3, line 53 - column 4, line 31; fig. 2 * | 1,4,5 |
| Y | * Column 2, lines 20-51; column 3, line 53 - column 4, line 31; fig. 2 * | 2,6 |
| | -- | |
| X | US - A - 3 179 904 (PAULSEN)<br>* Column 5, lines 18-42; fig. 5 * | 1,4 |
| Y | * Column 5, lines 18-42; fig. 5 * | 2,6 |
| | -- | |
| Y | DE - A1 - 2 754 342 (GUTEHOFFNUNGS-HÜTTE)<br>* Page 3, line 2 - page 4, line 27; page 5, line 15 - page 6, line 11; fig. 2 * | 4 |
| | -- | |
| P,Y | EP - A1 - 0 040 067 (JUNKOSHA) (18-11-1981)<br>* Page 2, line 33 - page 3, line 26; fig. 3,5 * | 1,2,5,6 |
| | & GB-A-2 075 744 (18-11-1981) | |
| | ---- | |

### CLASSIFICATION OF THE APPLICATION (Int. Cl. 3)

H 01 B 7/08
H 01 P 3/08

### TECHNICAL FIELDS SEARCHED (Int.Cl. 3)

H 01 B 7/00
H 01 B 11/00
H 01 B 3/00
H 01 P 3/00

### CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| | The present search report has been drawn up for all claims |
|---|---|
| X | |

| Place of search | Date of completion of the search | Examiner |
|---|---|---|
| VIENNA | 25-05-1982 | KUTZELNIGG |

EPO Form 1503.1 06.78